# FASCICULE DE BREVET EUROPEEN

(11) **EP 2 535 933 B1**
(45) Date de publication et mention de la délivrance du brevet: **19.03.2014**
(21) Numéro de dépôt: 12168456.7
(22) Date de dépôt: 18.05.2012
(51) Int. Cl.: H01L 23/58, H01L 21/763

(54) **Puce de circuit intégré comprenant un dispositif de protection contre des attaques**
Chip mit einem integrierten Schaltkreis und einer Schutzvorrichtung gegen Angriffe
Integrated circuit chip comprising protecting means against attacks

(30) Priorité: 17.06.2011 FR 1155343
(43) Date de publication de la demande: 19.12.2012
(73) Titulaire: STMicroelectronics (Rousset) SAS, 13790 Rousset (FR)
(72) Inventeur: Lisart, Mathieu, 13100 Aix en Provence (FR); Sarafianos, Alexandre, 13014 Marseille (FR); Gagliano, Olivier, 13013 Marseille (FR); Mantelli, Marc, 13710 Fuveau (FR)
(74) Mandataire: de Beaumont, Michel

(56) Documents cités:
- EP-A2- 2 109 139
- US-A- 4 862 240
- US-A- 6 010 939
- US-A1- 2006 180 939
- US-A1- 2010 187 525

## Description

### Domaine de l'invention

La présente invention concerne la protection d'une puce de circuit intégré contre des attaques visant à obtenir des informations confidentielles protégées.

### Exposé de l'art antérieur

Dans certains dispositifs sécurisés tels que des cartes de paiement, des puces de circuits intégrés sont susceptibles de traiter et/ou de stocker des données sensibles, par exemple des clés de chiffrement. Ces puces peuvent faire l'objet de manipulations frauduleuses visant à obtenir des informations confidentielles protégées.

Parmi les attaques connues, les attaques dites "attaques par faute", consistent à perturber volontairement le fonctionnement de la puce, et à analyser l'influence des perturbations sur son comportement. L'attaquant s'intéresse notamment à l'influence des perturbations sur des données telles que des signaux de sortie, la consommation, ou des temps de réponse. Il est susceptible d'en déduire, par des études statistiques ou autres, des informations sensibles telles que des algorithmes mis en oeuvre par la puce et éventuellement des clés de chiffrement.

Pour provoquer volontairement des anomalies dans les circuits d'une puce, un mode d'attaque consiste à bombarder des zones de la puce par un faisceau laser alors que la puce est en fonctionnement. On peut ainsi injecter des fautes dans certaines cellules mémoires et/ou affecter le comportement de certains composants. En raison de la présence de pistes métalliques d'interconnexion du côté de la face avant du substrat, les attaques laser sont souvent réalisées par la face arrière de la puce. L'attaquant peut prévoir une étape préliminaire d'amincissement du substrat de la puce, ce qui permet de minimiser l'atténuation du faisceau par le substrat et donc d'améliorer l'efficacité de l'attaque.

Pour se prémunir contre les fraudes, on a proposé des puces comprenant un dispositif de détection d'attaque, couplé à un circuit de protection de la puce. Lorsqu'une attaque est détectée, le circuit de protection met en oeuvre des mesures de protection, d'aliénation, ou de destruction des données sensibles. Par exemple, on peut prévoir, lorsqu'une attaque est détectée, d'interrompre l'alimentation de la puce ou de provoquer sa réinitialisation, de façon à minimiser le temps pendant lequel l'attaquant peut étudier la réponse de la puce à une perturbation.

Les solutions de détection d'attaque peuvent être logiques. Elles consistent par exemple à introduire régulièrement dans les calculs des tests d'intégrité permettant de s'assurer que des données n'ont pas été modifiées. Ces solutions présentent l'inconvénient d'introduire des étapes de calcul supplémentaires, augmentant ainsi les temps de réponse de la puce. En outre, les tests d'intégrité ne peuvent pas détecter toutes les perturbations provoquées par un attaquant. Ce dernier dispose donc d'une certaine marge de manoeuvre susceptible de lui permettre d'acquérir des informations sensibles.

D'autres solutions de détection d'attaque, dites physiques, comportent des capteurs sensibles aux variations de température, aux ultraviolets, ou aux rayons X, permettant de déceler des activités suspectes. De même que les solutions logiques, ces solutions ne sont pas parfaitement fiables. En effet, avant la détection de l'attaque, l'attaquant dispose d'une marge de manoeuvre susceptible de lui permettre d'obtenir des informations sensibles. De plus, la mise en oeuvre de ces solutions est complexe et augmente la surface de silicium nécessaire à la réalisation de la puce.

Un exemple de dispositif connu de protection d'un circuit intégré contre une attaque laser est décrit dans la demande de brevet EP2109139.

### Résumé

Ainsi, un objet d'un mode de réalisation de la présente invention est de proposer un dispositif de protection d'une puce de circuit intégré contre des attaques, palliant au moins en partie certains des inconvénients des solutions existantes.

Les inventeurs proposent ici un dispositif de protection permettant, au lieu de détecter qu'une attaque est en cours et de mettre en oeuvre des mesures de protection, d'aliénation, ou de destruction des données confidentielles, comme le font les dispositifs de protections usuels, d'empêcher que l'attaque ne provoque des anomalies de fonctionnement dans les circuits de la puce. L'attaquant ne sera alors plus en mesure d'injecter des fautes dans les circuits de la puce pour en déduire des informations sensibles.

Un objet d'un mode de réalisation de la présente invention est de prévoir un dispositif de protection permettant d'empêcher l'injection de fautes par un faisceau laser.

Un objet d'un mode de réalisation de la présente invention est de prévoir un dispositif de protection n'augmentant pas la surface semiconductrice nécessaire à la réalisation de la puce.

Un objet d'un mode de réalisation de la présente invention est de prévoir un dispositif de protection permettant en outre de détecter si une attaque est en cours.

Ainsi, la présente invention prévoit une puce de circuit intégré selon la revendication 1 comprenant : une pluralité de caissons parallèles de types de conductivité alternés formés dans la partie supérieure d'un substrat semiconducteur d'un premier type de conductivité ; dans chaque caisson du premier type, une pluralité de transistors MOS à canal du second type de conductivité, et dans chaque caisson du second type, une pluralité de transistors MOS à canal du premier type, des transistors de caissons voisins étant reliés en inverseurs ; et un dispositif de protection contre des attaques, comprenant : une couche du second type s'étendant sous la pluralité de caissons, depuis la face inférieure desdits caissons ; et des régions d'isolation latérale entre les caissons, les régions d'isolation latérales s'étendant depuis la face supérieure des caissons jusqu'à la couche du second type, les régions d'isolation latérale étant des tranchées à parois isolées remplies d'un matériau conducteur, la puce comprenant en outre au moins un détecteur associé à au moins une des régions d'isolation latérale, ce détecteur étant adapté à détecter des variations du potentiel du matériau conducteur de cette région d'isolation latérale.

Selon un mode de réalisation de la présente invention, les régions d'isolation latérale traversent entièrement la couche du second type et s'arrêtent dans le substrat.

Selon un mode de réalisation de la présente invention, les régions d'isolation latérale s'étendent jusqu'à une profondeur supérieure à 2 µm.

Selon un mode de réalisation de la présente invention, le matériau conducteur est du silicium polycristallin.

Selon un mode de réalisation de la présente invention, le détecteur est choisi pour détecter des variations du potentiel du matériau conducteur susceptibles de résulter d'un bombardement de la puce par un faisceau laser.

Selon un mode de réalisation de la présente invention, le détecteur comprend un comparateur dont une première borne d'entrée est maintenue, en fonctionnement, à un potentiel de référence, et dont une seconde borne d'entrée est reliée au matériau conducteur.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1A est une vue de dessus représentant de façon schématique et partielle un exemple de réalisation d'une puce de circuit intégré dans l'état de l'art ;
les figures 1B, 1C et 1D sont des vues en coupe selon les plans A-A, B-B et C-C de la figure 1A ;
la figure 2A est une vue de dessus représentant de façon schématique et partielle certains aspects d'une puce de circuit intégré protégée contre des attaques selon l'invention ;
les figures 2B, 2C et 2D sont des vues en coupe selon les plans A-A, B-B et C-C de la figure 2A ;
la figure 3 est une vue en coupe schématique d'un mode de réalisation selon l'invention d'une puce de circuit intégré protégée contre des attaques, comportant un dispositif de détection d'attaques ; et
la figure 4 est un chronogramme illustrant l'évolution d'un signal du dispositif de détection d'attaques de la puce de la figure 3.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

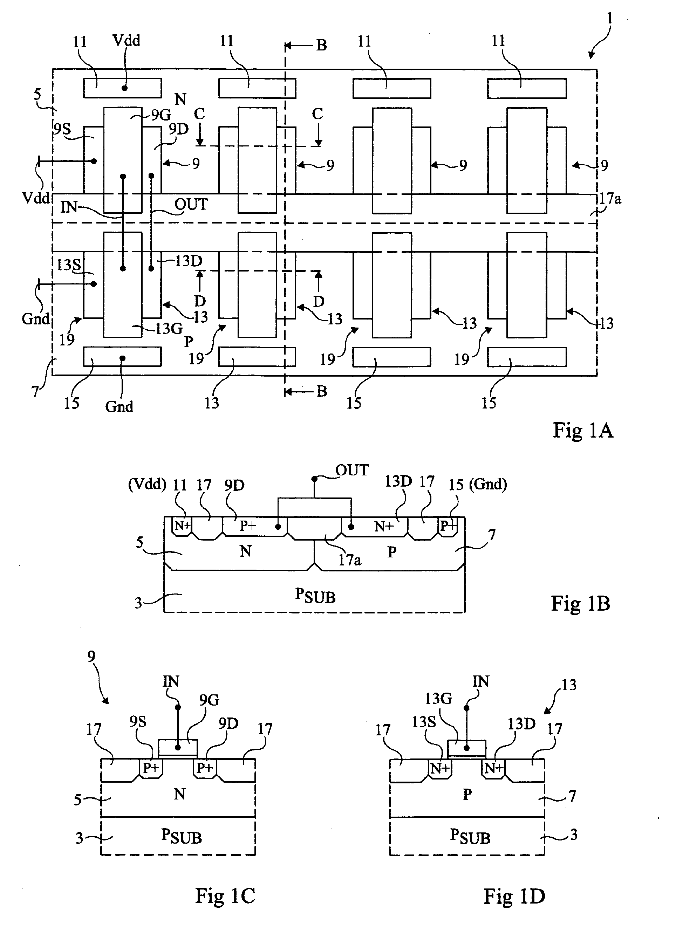

Les figures 1A à 1D représentent de façon schématique et partielle un exemple de réalisation d'une puce 1 de circuit intégré. La figure 1A est une vue de dessus de la puce 1, et les figures 1B, 1C et 1D sont des vues en coupe, respectivement selon les plans A-A, B-B et C-C de la figure 1A.

La puce 1 est formée à partir d'un substrat semiconducteur 3 (P_{SUB}) faiblement dopé de type P, par exemple un substrat de silicium. Des caissons juxtaposés de types de conductivité alternés sont formés dans la partie supérieure du substrat 3. Dans cet exemple, seuls deux caissons 5 et 7 ont été représentés, respectivement de type N et de type P, ayant en vue de dessus la forme de bandes parallèles juxtaposées (en traits pointillés sur la figure 1A). En pratique, la puce 1 peut comprendre un grand nombre de caissons parallèles juxtaposés de types de conductivité alternés.

Le caisson 5, de type N, comprend une pluralité de transistors MOS à canal P 9. Chaque transistor 9 comprend des régions de source 9S et de drain 9D, fortement dopées de type P (P+), délimitées par une grille conductrice isolée 9G formée à la surface du caisson 5. Le caisson 5 comprend en outre une pluralité de régions 11 fortement dopées de type N, formant des prises de contact de polarisation du caisson. Dans cet exemple, une prise de contact 11 est disposée au voisinage de chaque transistor 9.

Le caisson 7, de type P, comprend une pluralité de transistors MOS à canal N 13. Chaque transistor 13 comprend des régions de source 13S et de drain 13D, fortement dopées de type N (N+), délimitées par une grille conductrice isolée 13G formée à la surface du caisson 7. Le caisson 7 comprend en outre une pluralité de régions 15 fortement dopées de type P, formant des prises de contact de polarisation du caisson. Dans cet exemple, une prise de contact 15 est disposée au voisinage de chaque transistor 13.

Des régions isolantes 17 sont formées dans la partie supérieure des caissons 5 et 7 pour isoler les transistors les uns des autres et des prises de contact. En particulier, une région isolante 17a ayant, en vue de dessus, la forme d'une bande parallèle aux caissons 5 et 7, s'étend sans discontinuité au-dessus de la zone de jonction entre les caissons 5 et 7, isolant les transistors 9 des transistors 13. Les régions isolantes 17 et 17a sont par exemple des tranchées d'environ 100 à 300 nm de profondeur, remplies d'oxyde de silicium. De telles tranchées peuvent être formées selon un procédé couramment désigné dans la technique par le sigle STI, de l'anglais "Shallow Trench Isolation" - isolation par tranchée peu profonde.

Dans la puce 1, chaque transistor 9 du caisson 5 est, en vue de dessus, disposé à proximité d'un transistor 13 du caisson 7. Les transistors 9 et 13 voisins sont montés en inverseur, c'est-à-dire que la grille 9G du transistor 9 est connectée à la grille 13G du transistor 13, formant la borne d'entrée d'un inverseur 19, et que le drain 9D du transistor 9 est connecté au drain 13D du transistor 13, formant la borne de sortie OUT de l'inverseur 19. Les interconnexions grille-grille et drain-drain sont réalisées par des pistes conductrices non représentées, par exemple en silicium polycristallin ou en métal. A titre d'exemple, en fonctionnement, la source 9S du transistor 9 est à un potentiel d'alimentation haut Vdd, la source 13S du transistor 13 est à un potentiel d'alimentation bas Gnd, les prises de polarisation 11 du caisson 5 et 15 du caisson 7 sont respectivement au potentiel haut Vdd et au potentiel bas Gnd, et le substrat 3 est au potentiel bas Gnd.

Les inverseurs 19 constituent des cellules élémentaires de la puce 1. Ils sont reliés entre eux par des pistes conductrices non représentées, pour former des blocs mettant en oeuvre des fonctions de la puce.

Les inventeurs ont étudié les effets d'un bombardement de la puce 1 par un faisceau laser. Ils ont constaté l'apparition de courants parasites liés à la formation de paires électrons trous au niveau des jonctions PN polarisées en inverse, et notamment au niveau des jonctions PN entre le caisson 5 et le caisson 7 et entre le substrat 3 et le caisson 5. Ces courants sont susceptibles d'entraîner la mise en conductions de transistors bipolaires parasites, notamment un transistor NPN entre les prises 11 et le caisson 5 (N), le caisson 7 (P), et les régions de drain 13D (N), un transistor PNP entre les prises 15 et le caisson 7 (P), le caisson 5 (N), et les régions de drain 9D (P), un transistor PNP entre les régions de drain 9D (P), le caisson 5 (N) et le substrat 3 (P), et un transistor PNP entre les régions de source 9S (P), le caisson 5 (N) et le substrat 3 (P). Des transistors bipolaires passant par les régions de source 9S et 13S des transistors MOS 9 et 13 sont également susceptibles d'être mis en conduction. Il peut en résulter diverses anomalies de fonctionnement, par exemple des fautes logiques, c'est-à-dire que la valeur du signal sur la borne de sortie OUT d'un inverseur se trouve inversée par rapport à la valeur qui devrait normalement être présente sur cette borne compte tenu du signal appliqué sur la borne d'entrée IN. Il peut aussi se produire des fautes de délai, c'est-à-dire que la commutation du signal de sortie d'un inverseur est retardée par rapport à une commutation en l'absence du faisceau laser.

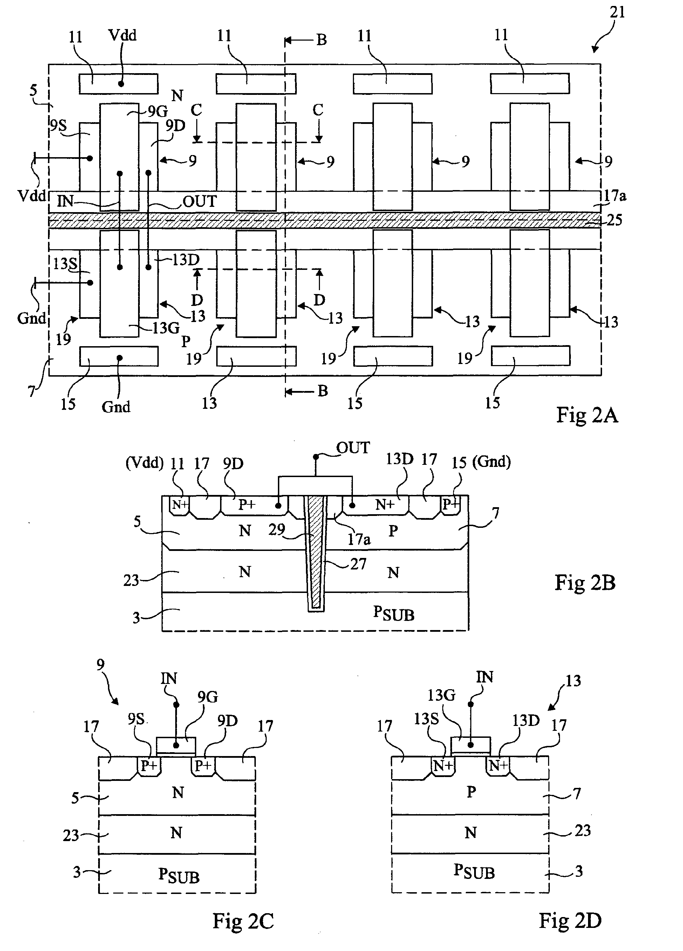

Les figures 2A à 2D représentent de façon schématique et partielle certains aspects d'une puce 21 de circuit intégré protégée contre des attaques selon l'invention. La figure 2A est une vue de dessus de la puce 21, et les figures 2B, 2C et 2D sont des vues en coupe, respectivement selon les plans A-A, B-B et C-C de la figure 2A.

Comme la puce 1 des figures 1A à 1D, la puce 21 comprend des caissons parallèles de types de conductivité alternés, des transistors MOS à canal P étant formés dans les caissons de type N et des transistors MOS à canal N étant formés dans les caissons de type P. Des transistors voisins de types opposés, formés dans des caissons de types de conductivité opposés, sont montés en inverseurs, constituant des cellules élémentaires de la puce 21. Les éléments communs aux puces 1 et 21 ont été désignés par de mêmes références sur les figures et ne seront pas décrits à nouveau en détail ci-après.

Dans la puce 21, une couche de type N 23 s'étend sous les caissons 5 et 7, à l'interface entre la face inférieure des caissons 5 et 7, et le substrat 3. A titre d'exemple, l'épaisseur des caissons 5 et 7 est comprise entre 0,5 et 1,5 µm, et l'épaisseur de la couche 23 est comprise entre 1 et 2 µm. On notera qu'en pratique, la couche 23 et les caissons 5, de type N, peuvent former une même région de type N.

Par ailleurs, dans la puce 21, les caissons parallèles 5 (de type N) et 7 (de type P) ne sont pas juxtaposés comme dans la puce 1 des figures 1A à 1D, mais sont séparés par une région isolante 25 qui s'étend depuis la face supérieure des caissons jusqu'à la couche N 23. La région 25 forme une paroi d'isolation latérale qui fait interface entre le caisson 5 et le caisson 7. Il n'existe donc pas, sous les inverseurs 19, de jonctions PN latérales entre les caissons 5 et 7, comme c'est le cas dans la puce 1 des figures 1A à 1D.

Dans l'exemple représenté, la région 25 traverse entièrement la couche de type N 23, jusqu'à déboucher dans le substrat 3. La région 25 peut être interrompue ou ouverte dans des régions séparant deux inverseurs de la puce ou dans des régions ne comportant pas de transistors MOS (aucune interruption ou ouverture n'est visible sur les figures 2A à 2D). De telles interruptions permettent de garantir l'uniformité de la polarisation de la couche 23. Dans une variante de réalisation, la région 25 peut s'arrêter à une profondeur intermédiaire de la couche 23, sans déborder dans le substrat 3.

Dans cet exemple, la région isolante 25 s'étend à partir de la face supérieure de la région isolante superficielle 17a séparant les transistors 9 du caisson 5 des transistors 13 du caisson 7. En vue de dessus (figure 2A), la région isolante 25 a la forme d'une bande, éventuellement interrompue dans certaines régions de la puce, parallèle aux caissons 5 et 7, de largeur inférieure à la bande 17a, et coïncidant sensiblement avec la partie centrale de la bande 17a. Ainsi, la prévision de la région isolante 25 n'entraîne pas une augmentation de la surface semiconductrice nécessaire à la réalisation de la puce. Dans une variante de réalisation, on pourra se passer de la région d'isolation superficielle 17a.

La région isolante 25 est par exemple une tranchée d'environ 2 à 4 µm de profondeur et d'environ 200 à 500 nm de largeur, dont les parois latérales et le fond sont revêtus par un film 27 en un matériau isolant tel que l'oxyde de silicium, et remplie d'un matériau conducteur 29 tel que du silicium polycristallin. De telles tranchées peuvent être formées selon un procédé couramment désigné dans la technique par le sigle DTI, de l'anglais "Deep Trench Isolation" - isolation par tranchée profonde. Dans une variante de réalisation, la tranchée 25 peut être entièrement remplie d'un matériau isolant tel que l'oxyde de silicium. Toute méthode adaptée à former une tranchée d'isolation latérale suffisamment profonde pourra être utilisée.

Sur les figures 2A à 2D, seuls deux caissons parallèles 5 et 7 ont été représentés. Toutefois, en pratique, la puce 21 peut comprendre un grand nombre de caissons parallèles de types de conductivité alternés, séparés les uns des autres par des régions 25 ayant, en vue de dessus, la forme de bandes (ou de tronçons de bandes alignés et disjoints) parallèles aux caissons 5 et 7. Ainsi, dans la puce 21, les transistors 9 et 13 constitutifs d'un même inverseur 19 sont séparés par une portion de tranchée isolante 25.

Les essais effectués par les inventeurs ont montré que le bombardement d'une puce du type décrit en relation avec les figures 2A à 2D par un faisceau laser ne provoque pas d'anomalies de fonctionnement. En présence du faisceau laser, il apparaît bien un courant parasite relativement important dans le substrat 3, lié à la formation de paires électrons trous au niveau de la jonction PN polarisée en inverse formée entre le substrat 3 et la couche 23. Toutefois, ce courant parasite n'a aucune incidence sur le fonctionnement des circuits de la puce. En particulier, du fait de la présence de la couche 23 et des régions isolantes 25, aucun transistor bipolaire parasite n'est susceptible d'être mis en conduction sous l'effet du faisceau laser. Dans le cas où la région d'isolation latérale 25 comprend des ouvertures dans certaines régions de la puce, il subsiste, dans ces régions, des jonctions PN latérales entre les caissons 5 et 7. Toutefois, ces jonctions sont de faible surface et suffisamment éloignées des inverseurs 19 pour ne pas permettre l'injection de fautes dans des circuits de la puce.

Ainsi, dans la puce 21, la couche 23 et les régions isolantes 25 sont des éléments d'un dispositif de protection contre des attaques permettant non pas de détecter une attaque puis de protéger, aliéner, ou détruire les données sensibles de la puce comme le font les dispositifs de protection usuels, mais d'empêcher la conséquence de l'attaque, c'est-à-dire l'injection de fautes ou anomalies de fonctionnement dans les circuits de la puce.

Un avantage du dispositif de protection proposé est qu'il permet de protéger la puce non seulement contre des attaques laser, mais aussi contre d'autres types d'attaque, par exemple des attaques par injection de fautes à l'aide d'un champ électromagnétique.

Un autre avantage d'un tel dispositif de protection est qu'il n'entraîne pas une augmentation de la surface de silicium nécessaire pour réaliser la puce.

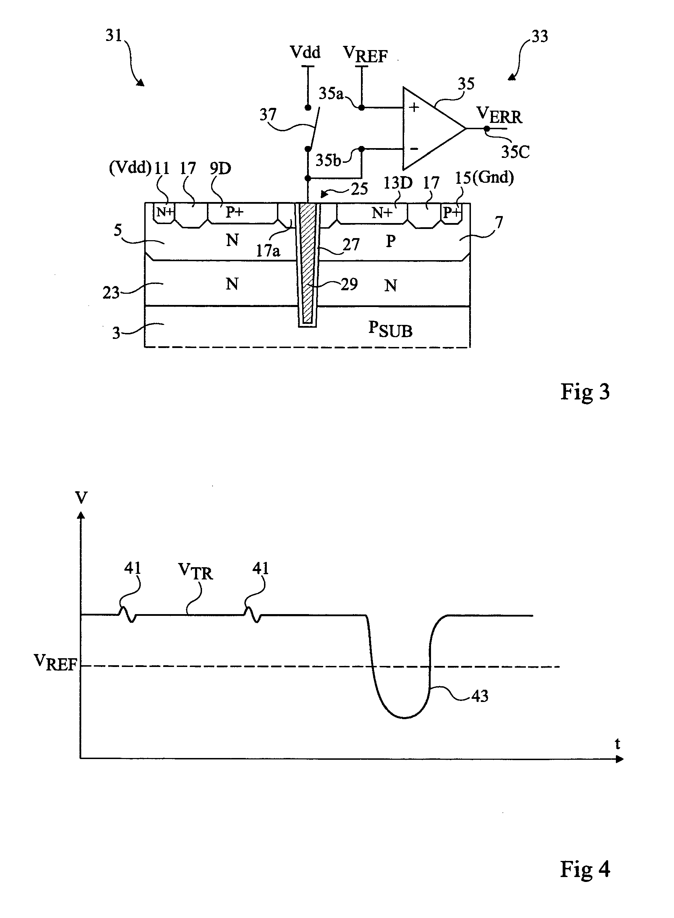

La figure 3 représente de façon schématique et partielle une puce de circuit intégré protégée contre des attaques selon l'invention. La puce 31 de la figure 3 comprend un dispositif de protection permettant non seulement d'empêcher l'injection de fautes, comme dans la puce 21 décrite en relation avec les figures 2A à 2D, mais aussi de détecter si une attaque est en cours.

La figure 3 est une vue en coupe dans le même plan que la figure 2B. La puce 31 comprend les mêmes éléments que la puce 21 de la figure 2B, et comprend en outre un circuit de détection d'attaques 33. Par souci de clarté, le circuit 33 a été représenté sous la forme d'un schéma électrique relié à la puce 31. En pratique, le circuit 33 peut être intégré à la puce 31, ou être un circuit externe à la puce 31.

Pour détecter qu'une attaque est en cours, les inventeurs proposent de détecter des variations anormales du potentiel V_{TR} du matériau conducteur 29 remplissant des tranchées 25 disposées entre des caissons parallèles voisins.

La région conductrice 29 constitue une électrode d'une pluralité de capacités parasites, notamment entre le matériau 29 et le caisson 5, entre le matériau 29 et le caisson 7, entre le matériau 29 et la couche 23, et entre le matériau 29 et le substrat 3. D'autres capacités parasites existent dans la puce 31, par exemple au niveau des jonctions PN entre le substrat 3 et la couche 23, et entre le caisson 7 et la couche 23.

Le bombardement de la puce par un faisceau laser entraîne une modification rapide des potentiels de polarisation du substrat 3, de la couche 23, et/ou des caissons 5 et 7. Les variations des potentiels de polarisation sont transmises par le réseau de capacités parasites susmentionné, et se traduisent par une variation du potentiel de la région conductrice 29.

On propose ici de détecter, à l'aide du circuit 33, des variations du potentiel de la région conductrice 29, susceptibles de correspondre à une attaque frauduleuse. Une fois l'attaque détectée, diverses mesures de protection, d'aliénation, ou de destruction des données confidentielles peuvent être mises en oeuvre.

Dans cet exemple, le circuit 33 comprend un comparateur 35 comportant des bornes d'entrée 35a et 35b et une borne de sortie 35c. La borne d'entrée 35b est reliée électriquement au matériau conducteur 29 remplissant la tranchée à parois isolées 25. En fonctionnement, un potentiel de référence V_{REF} est appliqué à la borne d'entrée 35a et la borne de sortie 35c fournit un signal V_{ERR} susceptible de commuter entre une valeur haute et une valeur basse selon que le potentiel V_{TR} du matériau conducteur 29 est supérieur ou inférieur au potentiel V_{REF}. Le matériau conducteur 29 remplissant la tranchée 25 est en outre relié à une borne de potentiel haut V_{DD} par l'intermédiaire d'un interrupteur 37. En fonctionnement, l'interrupteur 37, normalement ouvert, est fermé de façon périodique, par exemple à chaque front montant ou descendant d'un signal d'horloge de la puce, de façon à maintenir le matériau conducteur 29 à un potentiel flottant sensiblement constant. En variante, un potentiel de polarisation peut être appliqué en permanence au matériau conducteur 29 (polarisation non flottante).

La figure 4 est un chronogramme illustrant l'évolution du potentiel V_{TR} de la région conductrice 29 lors du fonctionnement de la puce. En fonctionnement normal, le potentiel V_{TR} est maintenu à un potentiel supérieur au potentiel B_{REF} appliqué sur la borne d'entrée 35a du comparateur 35. A titre d'exemple, le potentiel V_{REF} est d'approximativement 0,5 V, et le potentiel V_{TR} est maintenu à une valeur sensiblement constante de l'ordre de 0,7 V.

On observe des pics 41 sur le signal V_{TR}, correspondant à des variations rapides et de faible amplitude du potentiel V_{TR}. Les pics 41 sont la conséquence de phénomènes transitoires normaux se produisant lors du fonctionnement de la puce. A titre d'exemple, l'amplitude des pics 41 est inférieure à 0,1 V.

Sur le chronogramme de la figure 4, on observe en outre un creux 43 correspondant à une chute brutale et de forte amplitude du potentiel V_{TR}. Une telle chute de potentiel se produit typiquement en présence d'une attaque frauduleuse, par exemple lors du bombardement de la puce par un faisceau laser pulsé. Plus généralement, lors d'une attaque frauduleuse, une variation rapide du potentiel V_{TR} se produit dans les régions conductrices 29 de la zone attaquée. A titre d'exemple, des variations d'amplitude supérieure à 0,3 V sont typiquement observées en cas d'attaque laser sur des puces alimentées sous 1,2 V. Le potentiel V_{TR} chute alors à une valeur inférieure au potentiel V_{REF}, conduisant à une détection de l'attaque par le circuit 33.

En pratique, plusieurs circuits de détection 33 peuvent être prévus sur la puce 31. On peut par exemple associer à chaque région 25 de séparation des caissons de la puce, un ou plusieurs circuits de détection 33. On peut alternativement ne prévoir des circuits de détection 33 que dans les zones les plus sensibles de la puce. On peut en outre prévoir, sur une même puce 31, des circuits de détection 33 présentant des seuils de détections distincts, par exemple en appliquant des potentiels de référence V_{REF} distincts sur les bornes d'entrées 35a des différents comparateurs 35. On notera que l'invention ne se restreint pas à l'utilisation du circuit de détection 33 décrit ci-dessus. L'homme de l'art saura prévoir tout autre circuit adapté à détecter des variations du potentiel des régions conductrices 29 susceptibles de correspondre à une attaque frauduleuse.

Un avantage du dispositif de protection décrit en relation avec les figures 3 et 4 est qu'il offre une sécurité accrue, puisqu'en plus d'empêcher l'injection de fautes, comme le fait le dispositif de protection décrit en relation avec les figures 2A à 2D, il permet de détecter qu'une attaque est en cours. Ceci permet de prévoir des mesures de protection supplémentaires telles que la réinitialisation de la puce en cas d'attaque.

Des modes de réalisation particuliers de la présente invention ont été décrits. Diverses variantes et modifications dans le cadre de la portée des revendications apparaîtront à l'homme de l'art.

En particulier, on a décrit ci-dessus des modes de réalisation d'une puce de circuit intégré protégée contre des attaques laser, cette puce comprenant des caissons parallèles de types de conductivité alternés formés dans la partie supérieure d'un substrat semiconducteur, les caissons étant séparés les uns des autres par des régions isolantes 25. L'invention ne se restreint pas à l'exemple particulier décrit ci-dessus dans lequel les caissons ont, en vue de dessus, la forme de bandes parallèles. Par caissons parallèles, on entend ici plus généralement des caissons voisins disposés de façon qu'une face d'un premier caisson soit en regard d'une face du second caisson et sensiblement parallèle à cette face. Dans la structure proposée, une tranchée d'isolation 25 fait interface entre lesdites faces sensiblement parallèles.

De plus, on a décrit ci-dessus des exemples de puces de circuit intégré formées à partir d'un substrat de type P. L'homme de l'art saura adapter le dispositif de protection proposé à une puce formée à partir d'un substrat de type N.

## Revendications

1. Puce de circuit intégré comprenant :
une pluralité de caissons (5, 7) parallèles de types de conductivité alternés formés dans la partie supérieure d'un substrat semiconducteur (3) d'un premier type de conductivité (P) ;
dans chaque caisson (7) du premier type (P), une pluralité de transistors MOS (13) à canal du second type de conductivité (N), et dans chaque caisson (5) du second type (N), une pluralité de transistors MOS (9) à canal du premier type (P), des transistors de caissons voisins étant reliés en inverseurs (19) ; et
un dispositif de protection contre des attaques, comprenant :
une couche (23) du second type (N) s'étendant sous ladite pluralité de caissons (5, 7), depuis la face inférieure desdits caissons ; et
des régions d'isolation latérale (25) entre les caissons, lesdites régions (25) s'étendant depuis la face supérieure des caissons jusqu'à ladite couche (23),
lesdites régions (25) d'isolation latérale étant des tranchées à parois isolées remplies d'un matériau conducteur (29), la puce comprenant en outre au moins un détecteur (33) associé à au moins une desdites régions (25) d'isolation latérale, ledit au moins un détecteur étant adapté à détecter des variations du potentiel du matériau conducteur (29) de ladite au moins une région (25) d'isolation latérale.

2. Puce selon la revendication 1, dans laquelle les régions (25) d'isolation latérale traversent entièrement ladite couche (23) et s'arrêtent dans le substrat (3).

3. Puce selon la revendication 1 ou 2, dans laquelle les régions (25) d'isolation latérale s'étendent jusqu'à une profondeur supérieure à 2 µm.

4. Puce selon l'une quelconque des revendications 1 à 3, dans laquelle le matériau conducteur (29) est du silicium polycristallin.

5. Puce selon l'une quelconque des revendications 1 à 4, dans laquelle ledit au moins un détecteur (33) est choisi pour détecter des variations du potentiel du matériau conducteur (29) susceptibles de résulter d'un bombardement de la puce par un faisceau laser.

6. Puce selon l'une quelconque des revendications 1 à 5, dans laquelle ledit au moins un détecteur (33) comprend un comparateur (35) dont une première borne d'entrée (35a) est maintenue, en fonctionnement, à un potentiel de référence (V_{REF}), et dont une seconde borne d'entrée (35b) est reliée audit matériau conducteur (29).

## Patentansprüche

1. Ein Chip mit einem integrierten Schaltkreis, wobei Folgendes vorgesehen ist:
eine Vielzahl von parallelen Vertiefungen (5, 7) alternativer Leitfähigkeitstypen, gebildet in dem oberen Teil des Halbleitersubstrats (3) eines ersten Leitfähigkeitstyps (P);
in jeder Vertiefung (7) des ersten Typs (P) eine Vielzahl von MOS Transistoren (13) mit einem Kanal des zweiten Leitfähigkeitstyps (N) und in jeder Vertiefung (5) des zweiten Typs (N) eine Vielzahl von MOS Transistoren (9) mit einem Kanal des ersten Typs (P), wobei Transistoren benachbarter Vertiefungen als Inverter (19) geschaltet sind; und
eine Vorrichtung zum Schutz gegenüber Angriffen, die Folgendes aufweist:
eine Schicht (23) des zweiten Typs (N), die sich unter die Vielzahl von Vertiefungen (5, 7) von der unteren Oberfläche (Unterseite) der Vertiefungen erstreckt; und
seitliche Isolationsregionen (25) zwischen den Vertiefungen, wobei die Regionen (25) sich von der Oberseite (oberen Oberfläche) der Vertiefungen zu der erwähnten Schicht (23) erstrecken,
wobei die seitlichen bzw. lateralen Isolationsregionen (25) Gräben sind mit isolierten Wänden gefüllt mit einem leitenden Material (29), wobei der Chip ferner mindestens einen Detektor (33) aufweist, und zwar assoziiert mit mindestens einer der erwähnten seitlichen Isolationsregionen (25),
wobei der erwähnte mindestens eine Detektor in der Lage ist, Spannungsveränderungen des leitenden Materials (29), der erwähnten mindestens einen seitlichen Isolationsregion (25) zu detektieren.

2. Der Chip nach Anspruch 1, wobei die seitlichen Isolationsregionen (25) die erwähnte Schicht (23) vollständig kreuzen und in dem Substrat (3) stoppen.

3. Der Chip nach Anspruch 1 oder 2, wobei die seitlichen Isolationsregionen (25) sich nach unten auf eine Tiefe größer als 2 µm erstrecken.

4. Der Chip nach einem der Ansprüche 1 bis 3, wobei das leitende Material (29) Polysilizium ist.

5. Der Chip nach einem der Ansprüche 1 bis 4, wobei der erwähnte mindestens eine Detektor (33) ausgewählt ist, um Spannungsänderungen des leitenden Materials (29) zu detektieren, die sich aus der Bombardierung des Chips durch einen Laserstrahl ergeben können.

6. Der Chip nach einem der Ansprüche 1 bis 5, wobei der erwähnte mindestens eine Detektor (33) einen Komparator (35) aufweist mit einem ersten Eingangsanschluss (35a), der mit Betrieb auf einer Bezugsspannung (V_{REF}) gehalten wird, und mit einem zweiten Eingangsanschluss (35b) verbunden mit dem leitenden Material (29).

## Claims

1. An integrated circuit chip comprising:
a plurality of parallel wells (5, 7) of alternated conductivity types formed in the upper portion of a semiconductor substrate (3) of a first conductivity type (P);
in each well (7) of the first type (P), a plurality of MOS transistors (13) having a channel of the second conductivity type (N), and in each well (5) of the second type (N), a plurality of MOS transistors (9) having a channel of the first type (P), transistors of neighboring wells being connected as inverters (19); and
a device of protection against attacks, comprising:
a layer (23) of the second type (N) extending under the plurality of wells (5, 7), from the lower surface of said wells; and
lateral insulation regions (25) between the wells, said regions (25) extending from the upper surface of the wells to said layer (23),
said lateral insulation regions (25) being trenches with insulated walls filled with a conductive material (29), the chip further comprising at least one detector (33) associated with at least one of said lateral insulation region (25) , said at least one detector being capable of detecting variations of the voltage of the conductive material (29) of said at least one lateral isolation region (25) .

2. The chip of claim 1, wherein the lateral insulation regions (25) entirely cross said layer (23) and stop in the substrate (3).

3. The chip of claim 1 or 2, wherein the lateral insulation regions (25) extend down to a depth greater than 2 µm.

4. The chip of any of claims 1 to 3, wherein the conductive material (29) is polysilicon.

5. The chip of any of claims 1 to 4, wherein said at least one detector (33) is selected to detect variations of the voltage of the conductive material (29) that may result from a bombarding of the chip by a laser beam.

6. The chip of any of claims 1 to 5, wherein said at least one detector (33) comprises a comparator (35) having a first input terminal (35a) maintained, in operation, at a reference voltage (V_{REF}), and having a second input terminal (35b) connected to said conductive material (29).
